# EUROPEAN PATENT APPLICATION

(11) **EP 2 365 528 A2**
(43) Date of publication of application: **14.09.2011**
(21) Application number: 11157443.0
(22) Date of filing: 09.03.2011
(51) Int. Cl.: H01L 27/15, H01L 33/36, H01L 33/32

(54) **Two light emitting diodes stacked in an n-p-n arrangement and LED package comprising the same**

(30) Priority: 09.03.2010 KR 20100020646
(71) Applicant: LG Innotek Co., Ltd., Seoul 100-714 (KR)
(72) Inventor: Jung, Myung Hoon, 100-714 Seoul (KR); Kang, Dae Sung, 100-714 Seoul (KR)
(74) Representative: Zardi, Marco

(57) **Abstract**

Disclosed are a light emitting device (100) and a light emitting device package having the same. The light emitting device (100) includes a first semiconductor layer (130) doped with N type dopants, a first active layer (140) on the first semiconductor layer (130), a second semiconductor layer (150) doped with P type dopants on the first active layer (140), a second active layer (160) on the second semiconductor layer (150), and a third semiconductor layer (170) doped with N type dopants on the second active layer (160). A thickness of the second semiconductor layer (150) is in a range of 2000Å to 4000Å, and doping concentration of the P type dopants doped in the second semiconductor layer (150) is in a range of 10¹⁸cm⁻³ to 10²¹ cm⁻³.

## Description

### FIELD OF INVENTION

The disclosure relates to a light emitting device, a light emitting device package and lighting apparatus.

### PRIOR ART

A light emitting diode (LED) is a semiconductor light emitting device that converts a current into light. Recently, the LED can generate light having high brightness, so that the LED has been extensively used as a light source for a display device, a vehicle, or a lighting device. In addition, the LED can realize a white color having superior light efficiency by employing luminescence material or combining LEDs having various colors.

In order to improve the brightness and the performance of the LED, various attempts have been performed to improve a light extracting structure, an active layer structure, current spreading, an electrode structure, and a structure of a light emitting diode package.

### SUMMARY OF INVENTION

The present invention provides a light emitting device having a new structure, a method of fabricating the same, and a light emitting device package.

The invention provides a light emitting device capable of improving light emission efficiency, a method of fabricating the same, and a light emitting device package.

According to an aspect of invention, a light emitting device comprises a first semiconductor layer, a first active layer on the first semiconductor layer, a second semiconductor layer doped on the first active layer, a second active layer on the second semiconductor layer, and a third semiconductor layer doped on the second active layer. The first and the third semiconductor layer may be doped with same type of dopants, while the second semiconductor layer may doped with the other type of dopants. For example, the first and the third semiconductor layer may be doped with N type dopants, and the second semiconductor layer may doped with P type dopants, and vice versa. Since the light emitting device comprises two active layer, more light can be generated in a unit area, thereby improve the intensity of illumination.

Preferably, a thickness of the second semiconductor layer is in a range of 2000Å to 4000Å, and doping concentration of the P type dopants doped in the second semiconductor layer is in a range of 10¹⁸cm⁻³ to 10²¹cm⁻³ . If the second semiconductor layer has the above thickness and/or doping concentration, the light extraction efficiency of the light emitting device can be improved since it has a thickness and/or doping concentration sufficient to emit a light generated from the first and second active layers through the lateral side portions of the second semiconductor layer.

In another aspect of the invention, a total thickness of the first semiconductor layer, the first active layer, the second semiconductor layer, the second active layer, and the third semiconductor layer is at least about 7µm. Due to the thickness, the light generated from the first and second active layers and can be effectively emitted through the lateral side portions of the light emitting device.

In another aspect of the invention, the first semiconductor layer, the first active layer, the second semiconductor layer, the second active layer, and the third semiconductor layer comprise a material having a compositional formula of InₓAl_{y}Ga_{1-x-y}N (0≤x≤1, 0≤y≤1, and 0≤x+y≤1).

In another aspect of the invention, the first and second active layers emit lights having same wavelength bands. The light emitted from the first active layer causes constructive interference with a light emitted from the first active layer, so that the brightness of the light emitted from the light emitting device can be improved. Alternatively, the first and second active layers may emit lights having wavelength bands different from each other. Therefore, the first light emitted from the first active layer is mixed with the second light emitted from the second active layer in color. Accordingly, the light emitted from the light emitting device can have various colors.

In another aspect of the invention, the light emitting device further comprises a first electrode on the first semiconductor layer, a second electrode on the second semiconductor layer, and a third electrode on the third semiconductor layer. In this way, power can be supplied to the lighting emitting device. Specifically, current can be flowed into the second electrode and flow outward through the first and the third electrode, or vice versa depending on the doping of first, second, and third semiconductor layer.

In another aspect of the invention, at least portions of the first, second, and third electrodes are aligned on a same diagonal plane. In addition, the first to third electrodes may be spaced apart from each other at the maximum distance. This causes power supplied from the first to third electrodes to be effectively spread throughout the whole region of the light emitting device.

In another aspect of the invention, top surfaces of the first semiconductor layer, the second semiconductor layer, and the third semiconductor layer may have a shape including a vertex, and the first, second, and third electrodes may be provided adjacent to vertexes, which are different from each other and formed on the top surfaces of the first semiconductor layer, the second semiconductor layer, and the third semiconductor layer, respectively.. This causes power supplied from the first to third electrodes to be effectively spread throughout the whole region of the light emitting device.

In another aspect of the invention, the light emitting device further comprises an undoped semiconductor layer, a buffer layer, and a substrate under the first semiconductor layer. Preferably, the light emitting device may further comprise at least one of a reflective layer and a conductive support member on the third semiconductor layer.

In another aspect of the invention, the light emitting device further comprises a fourth electrode on the second semiconductor layer and a fifth electrode on the first semiconductor layer.

According to the embodiment, a light emitting device package comprises a body, first and second electrode layers on the body, a light emitting device provided on the body and electrically connected to the first and second electrode layers, and a molding member surrounding the light emitting device on the body. The light emitting device comprises a first semiconductor layer doped with N type dopants, a first active layer on the first semiconductor layer, a second semiconductor layer doped with P type dopants on the first active layer, a second active layer on the second semiconductor layer, and a third semiconductor layer doped with N type dopants on the second active layer, and wherein a thickness of the second semiconductor layer is in a range of 2000Å to 4000Å, and doping concentration of the P type dopants doped into the second semiconductor layer is in a range of 10¹⁸cm⁻³ to 10²¹cm⁻³.

The embodiment can provide a light emitting device having a novel structure, a method of fabricating the same, and a light emitting device package.

The embodiment can provide a light emitting device capable of improving light emission efficiency, a method of fabricating the same, and a light emitting device package.

### BRIEF DESCRIPTION OF THE DRAWINGS

FIG. 1 is a sectional view showing a light emitting device according to a first embodiment;

FIG. 2 is a sectional view showing a light emitting device according to a second embodiment;

FIGS. 3 to 5 are views showing a method of fabricating the light emitting device according to the second embodiment;

FIG. 6 is a plan view showing the light emitting device according to the first embodiment;

FIG. 7 is a sectional view showing a light emitting device package comprising the light emitting device according to the embodiment; and

FIG. 8 is a perspective view showing a lighting apparatus comprising a light emitting device according to the embodiments.

### DETAILED DESCRIPTION OF THE EMBODIMENTS

In the description of the embodiments, it will be understood that, when a layer (or film), a region, a pattern, or a structure is referred to as being "on" or "under" another substrate, another layer (or film), another region, another pad, or another pattern, it can be "directly" or "indirectly" on the other substrate, layer (or film), region, pad, or pattern, or one or more intervening layers may also be present. Such a position of the layer has been described with reference to the drawings.

The thickness and size of each layer shown in the drawings may be exaggerated, omitted or schematically drawn for the purpose of convenience or clarity. In addition, the size of elements does not utterly reflect an actual size.

Hereinafter, a light emitting device, a method of manufacturing the same, and a light emitting device package according to the embodiments will be described with reference to accompanying drawings.

### <First Embodiment>

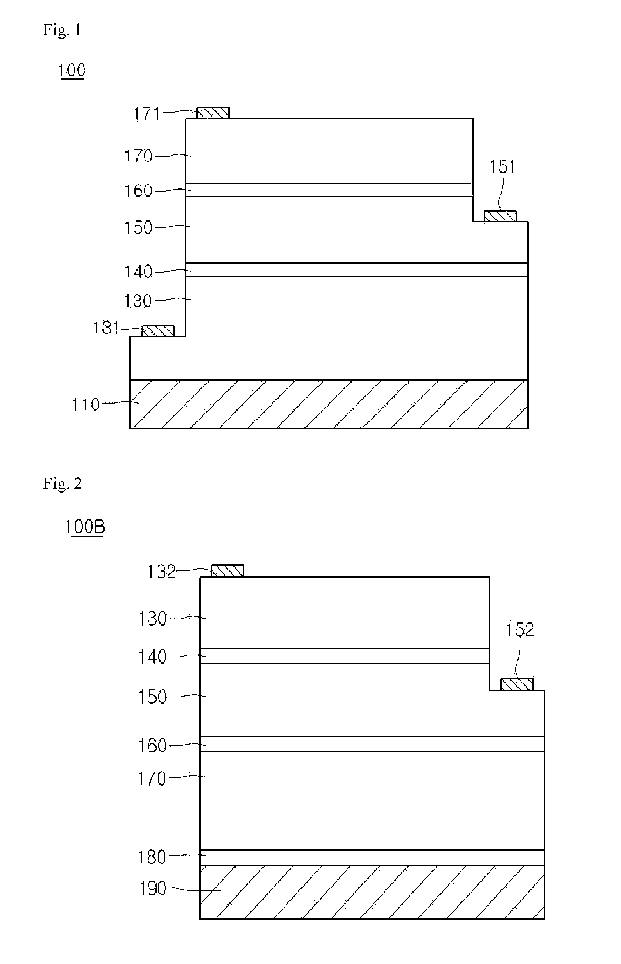

FIG. 1 is a sectional view showing a light emitting device 100 according to a first embodiment.

Referring to FIG. 1, the light emitting device 100 comprises a substrate 110, a first semiconductor layer 130 comprising N type dopants on at least a portion of the substrate 110, a first active layer 140 on the first semiconductor layer 130, a second semiconductor layer 150 comprising P type dopants on the first active layer 140, a second active layer 160 on the second semiconductor layer 150, and a third semiconductor layer 170 comprising N type dopants on the second active layer 160.

In addition, the first semiconductor layer 130 is provided thereon with a first electrode 131, the second semiconductor layer 150 is provided thereon with a second electrode 151, and the third semiconductor layer 170 is provided thereon with a third electrode 171. The first, second, and third electrodes 131, 151, and 171 may supply power to the light emitting device 100.

In this case, after performing a mesa-etching process to expose a portion of a top surface of the first and second semiconductor layers 130 and 150, the first and second electrodes 131 and 151 may be provided, but the embodiment is not limited thereto.

The second semiconductor layer 150 may be interposed between the first active layer 140 and the second active layer 160. The thickness of the second semiconductor layer 150 may be in the range of about 2000Å to about 4000Å.

Since the second semiconductor layer 150 comprises P type dopants, the second semiconductor layer 150 may supply holes to the first and second active layers 140 and 160.

In general, since the holes have mobility lower than that of electrons, the number of holes reaching the active layers from the semiconductor layer comprising P type dopants and actually recombined with electrons to generate a light is very restricted.

However, according to the embodiment, holes contained in the second semiconductor layer 150 may bi-directionally move toward the first and second active layers 140 and 160 provided on the top and bottom surfaces of the second semiconductor layer 150.

Therefore, the holes of the second semiconductor layer 150 are effectively supplied to the first and second active layers 140 and 160, and the ratio of holes recombined with electrons to emit a light is increased. Accordingly, the light extraction efficiency of the light emitting device 100 can be improved.

Hereinafter, the light emitting device 100 according to the first embodiment and the method of fabricating the same will be described while focusing on components thereof.

Referring to FIG. 1, the substrate 110 may comprise at least one of Al₂O₃, SiC, Si, GaAs, GaN, ZnO, GaP, InP, and Ge, but the embodiment is not limited thereto.

The first semiconductor layer 130 may be provided on the substrate 110. For example, the first semiconductor layer 130 may be realized by using a group III-V compound semiconductor.

The first semiconductor layer 130 may comprise a semiconductor layer including first conductive dopants. At least one of a buffer layer and an undoped semiconductor layer may be provided under the first semiconductor layer 130. In this case, at least a portion of the first semiconductor layer 130 may be doped with first conductive dopants.

For example, the buffer layer may be provided on the substrate 110, the undoped semiconductor layer may be provided on the buffer layer, and the first semiconductor layer 130 may be provided on the undoped semiconductor layer. However, the first semiconductor layer 130 may further comprise a plurality of layers, but the embodiment is not limited thereto.

The buffer layer reduces lattice constant mismatch between the substrate 110 and the first semiconductor layer 130, so that the first semiconductor layer 130 can be grown with a superior crystalline property. For example, the first semiconductor layer 130 may comprise a semiconductor material having a compositional formula of InₓAl_{y}Ga_{1-x-y}N (0≤x≤1, 0≤y≤1, and 0≤x+y≤1), but the embodiment is not limited thereto.

Since the undoped semiconductor layer is not doped with dopants, the undoped semiconductor layer has electrical conductivity lower than that of the first, second, and third semiconductor layers 130, 150, and 170. For example, the undoped semiconductor layer may comprise a semiconductor material having a compositional formula of InₓAl_{y}Ga_{1-x-y}N (0≤x≤1, 0≤y≤1, and 0≤x+y≤1), but the embodiment is not limited thereto. For example, the undoped semiconductor layer may comprise an un-doped GaN layer.

The first semiconductor layer 130 may comprise an N type semiconductor layer. The N type semiconductor layer may comprise a semiconductor material having a compositional formula of InₓAl_{y}Ga_{1-x-y}N (0≤x≤1, 0≤y≤1, and 0≤x+y≤1). The N type semiconductor layer may comprise one selected from the group consisting of InAlGaN, GaN, AlGaN, InGaN, AlN, InN, and AlInN and may be doped with N type dopants such as Si, Ge, Sn, and C.

The first semiconductor layer 130 may have a thickness of at least 2µm, so that the light emitted from the first and second active layers 140 and 160 can be smoothly discharged through the lateral side portion of the first semiconductor layer 130.

The first active layer 140 may be provided on the first semiconductor layer 130. The first active layer 140 may comprise a single quantum well structure or a multiple quantum well (MQW) structure. The first active layer 140 may generate a light by using carriers (electrons and holes) received from the first and second semiconductor layers 130 and 150.

For example, the first active layer 140 may comprise a semiconductor material having a compositional formula of InₓAl_{y}Ga_{1-x-y}N (0≤x≤1, 0≤y≤1, and 0≤x+y≤1).

The second semiconductor layer 150 may be formed on the first active layer 140. The second semiconductor layer 150 may comprise a P type semiconductor layer. The P type semiconductor layer may comprise a semiconductor material having a compositional formula of InₓAl_{y}Ga_{1-x-y}N (0≤x≤1, 0≤y≤1, and 0≤x+y≤1). The P type semiconductor layer may comprise a material selected from the group consisting of InAlGaN, GaN, AlGaN, InGaN, AlN, InN, and AlInN, and may be doped with P type dopants such as Mg, Zn, Be, C, and Cd.

In addition, a clad layer doped with N type or P type dopants may be formed above and/or under the first active layer 140, and the clad layer may comprise an AlGaN-based layer or an InAlGaN-based layer.

The second active layer 160 may be provided on the second semiconductor layer 150. The active layer 160 may have a single quantum well structure, a multiple quantum well structure, a quantum wire structure, or a quantum dot structure. The second active layer 160 may have the stack structure of well/barrier layers by using a group III-V compound semiconductor material. For example, the second active layer 160 may comprise at least one of InGaN/GaN, InGaN/AlGaN and InGaN/InGaN structures. The barrier layer may comprise a material having bandgap greater than that of the well layer, but the embodiment is not limited thereto. The second active layer 160 can generate a light by using carriers (electrons and holes) supplied from the second and third semiconductor layers 150 and 170. For example, the second active layer 160 may comprise a semiconductor material having a compositional formula of InₓAl_{y}Ga_{1-x-y}N (0≤x≤1, 0≤y≤1, and 0≤x+y≤1).

The second semiconductor layer 150 is interposed between the first active layer 140 and the second active layer 160. Accordingly, the second semiconductor layer 150 supplies carriers (holes or electrons) to the first and second active layers 140 and 160.

If the P type dopants are doped into the second semiconductor layer 150, the second semiconductor layer 150 supplies holes to the first and second active layers 140 and 160.

In general, since the holes have mobility lower than those of electrons, the number of holes reaching the active layers from the semiconductor layer including P type dopants and actually recombined with electrons to generate a light is very restricted.

However, according to the embodiment, holes contained in the second semiconductor layer 150 may bi-directionally move toward the first and second active layers 140 and 160 provided on the top and bottom surfaces of the second semiconductor layer 150. Accordingly, the use of holes of the second semiconductor layer 150 is increased, so that the light extraction efficiency of the light emitting device 100 can be improved.

The thickness of the second semiconductor layer 150 may be in the range of about 2000Å to about 4000Å. The doping concentration of the P type dopants may be in the range of about 10¹⁸cm⁻³ to 10²¹cm⁻³, but the embodiment is not limited thereto.

The second semiconductor layer 150 has a thickness sufficient to emit a light generated from the first and second active layers 140 and 160 through the lateral side portions of the second semiconductor layer 150. Therefore, if the second semiconductor layer 150 has the above thickness, the light extraction efficiency of the light emitting device 100 can be improved.

Since the first and second active layers 140 and 160 emit a light, the light emitting device 100 may have more various designs when comparing with a case in which the light emitting device 100 comprises one active layer.

For example, if the first and second active layers 140 and 160 emit a light having the same wavelength, the light emitted from the first active layer 140 causes constructive interference with a light emitted from the first active layer 140, so that the brightness of the light emitted from the light emitting device 100 can be improved.

In addition, if the first and second active layers 140 and 160 emit a light having different wavelengths, the first light emitted from the first active layer 140 is mixed with the second light emitted from the second active layer 160 in color. Accordingly, the light emitted from the light emitting device 100 can have various colors.

The third semiconductor layer 170 may be provided on the second active layer 160. The third semiconductor layer 170 may comprise an N type semiconductor layer, and the N type semiconductor layer may comprise a semiconductor material having a compositional formula of InₓAl_{y}Ga_{1-x-y}N (0≤x≤1, 0≤y≤1, and 0≤x+y≤1). For example, the third semiconductor layer 170 may comprise a material selected from the group consisting of InAlGaN, GaN, AlGaN, InGaN, AlN, InN, and AlInN, and may be doped with N type dopants such as Si, Ge, Sn, and C.

The third semiconductor layer 170 may have the thickness of at least 2µm For example, since the thickness between the first semiconductor layer 130 and the third semiconductor layer 170 may be at least 7µm, the light generated from the first and second active layers 140 and 160 can be effectively emitted through the lateral side portions of the light emitting device 100.

The first semiconductor layer 130, the first active layer 140, and the second semiconductor layer 150, the second active layer 160, and the third semiconductor layer 170 may be formed through a MOCVD (Metal Organic Chemical Vapor Deposition) scheme, a CVD (Chemical Vapor Deposition) scheme, a PECVD (Plasma-Enhanced Chemical Vapor Deposition) scheme, a MBE (Molecular Beam Epitaxy) scheme or an HVPE (Hydride Vapor Phase Epitaxy) scheme, but the embodiment is not limited thereto.

The light emitting device 100 according to the embodiment may comprise the first electrode 131 on the first semiconductor layer 130, the second electrode 151 on the second semiconductor layer 150, and the third electrode 171 on the third semiconductor layer 170. The first, second, and third electrodes 131, 151, and 171 may supply power to the light emitting device 100.

In this case, after performing a mesa-etching process to expose a portion of the top surface of the first and second semiconductor layers 130 and 150, the first and second electrodes 131 and 151 may be formed, but the embodiment is not limited thereto.

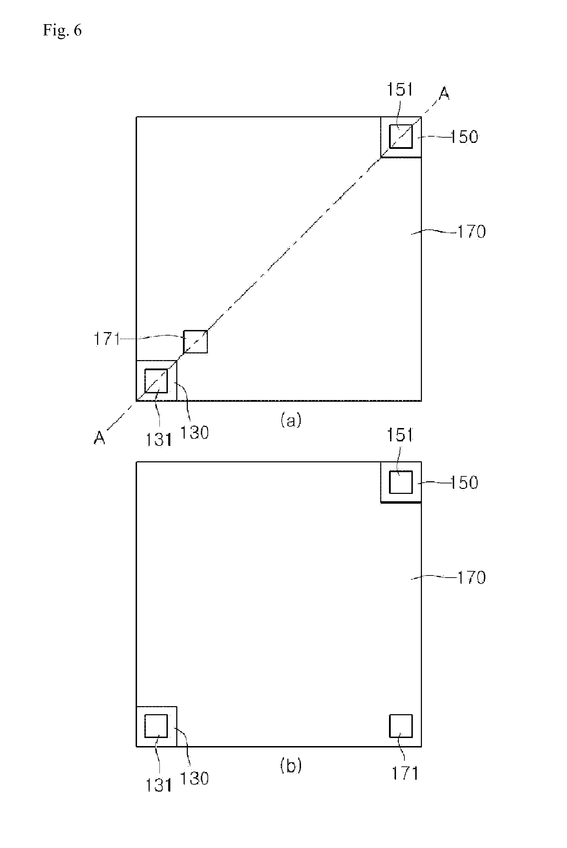

FIGS. 6A and 6B are plan views showing the light emitting device 100 according to the first embodiment.

Referring to FIG. 6A, at least a portion of the first electrode 131, the second electrode 151, and the third electrode 171 may be provided on the same diagonal plane. That is to say, in a plan view of FIG. 6A, a diagonal line can be defined from one corner to the another corner of the light emitting device 100. The diagonal plane can be defined as a plane intersecting the diagonal line perpendicularly to the top surface of semiconductor layers.

Referring to FIG. 6b, if the top surface of the light emitting device 100 is formed in the shape having vertexes, such as a rectangular shape or a polygonal shape, the first electrode 131, the second electrode 151, and the third electrode 171 may be formed in the vicinity of vertexes different from each other on the top surface of the light emitting device 100, but the embodiment is not limited thereto.

If the first to third electrodes 131, 151, and 171 are spaced apart from each other at the maximum distance, power supplied from the first to third electrodes 131 to 171 may be effectively spread throughout the whole region of the light emitting device 100.

Meanwhile, at least one of a transparent electrode layer or a reflective electrode layer may be interposed between the first semiconductor layer 130 and the first electrode 131, between the second semiconductor layer 150 and the second electrode 151, and between the third semiconductor layer 170 and the third electrode 171, but the embodiment is not limited thereto.

The transparent electrode layer or the reflective electrode layer transmits or reflects the light emitted from the light emitting device 100, and uniformly spread power throughout the whole region of the light emitting device 100. The transparent electrode layer or the reflective electrode layer may form ohmic contact between the electrodes 131, 151, and 171 and the semiconductor layers 130, 150, and 170.

The transparent electrode layer may comprise a material selected from the group consisting of ITO (Indium Tin Oxide), IZO (Indium Zinc Oxide), AZO (Aluminum Zinc Oxide), AGZO (Aluminum Gallium Zinc Oxide), IZTO (Indium Zinc Tin Oxide), IAZO (Indium Aluminum Zinc Oxide), IGZO (Indium Gallium Zinc Oxide), IGTO (Indium Gallium Tin Oxide), ATO (Antimony Tin Oxide), GZO (Gallium Zinc Oxide), IZON (IZO Nitride), ZnO, IrOx, RuOx, and NiO. The transparent electrode may comprise a material selected from the group consisting of Ag, Ni, Al, Rh, Pd, Ir, Ru, Mg, Zn, Pt, Au, Hf, and the combination thereof.

In order to improve the light extraction efficiency of the light emitting device 100, a concavo-convex pattern may be formed on the top surface of the light emitting device 100, but the embodiment is not limited thereto.

### <Second Embodiment>

Hereinafter, a light emitting device 100B according to the second embodiment and a method of fabricating the same will be described in detail. In the following description about the second embodiment, the structure and components same to those of the first embodiment will not be further described in order to avoid redundancy.

Although the light emitting device 100B according to the second embodiment is similar to the light emitting device 100 according to the first embodiment in basic structure, the light emitting device 100B has electrode arrangement different from those of the first light emitting device 100 according to the first embodiment.

FIG. 2 is a sectional view showing the light emitting device 100B according to the second embodiment.

Referring to FIG. 2, the light emitting device 100B comprises a conductive support member 190, a reflective layer 180 on the conductive support member 190, a third semiconductor layer 170 comprising N type dopants on the reflective layer 180, the second active layer 160 on the third semiconductor layer 170, the second semiconductor layer 150 comprising P type dopants on the second active layer 160, the first active layer 140 on the second semiconductor layer 150, and the first semiconductor layer 130 having at least a region doped with N type dopants on the first active layer 140.

In addition, the light emitting device 100B according to the embodiment may comprise a fourth electrode 152 on the second semiconductor layer 150 and a fifth electrode 132 on the first semiconductor layer 130. The fourth and fifth electrodes 152 and 132 may supply power to the light emitting device 100B together with the conductive support member 190.

After performing a mesa-etching to expose a portion of the top surface of the second semiconductor layer 150, the fourth electrode 152 may be formed, but the embodiment is not limited thereto.

The second semiconductor layer 150 may be interposed between the first active layer 140 and the second active layer 160. The thickness of the second semiconductor layer 150 may be in the range of about 2000Å to about 4000Å.

Since the second semiconductor layer 150 comprises P type dopants, holes may be supplied to the first and second active layers 140 and 160.

In general, since the holes have mobility lower than those of electrons, the number of holes reaching the active layer from the second semiconductor layer and actually recombined with electrons to generate a light is very restricted.

However, according to the embodiment, holes contained in the second semiconductor layer 150 may bi-directionally move toward the first and second active layers 140 and 160 provided on the top and bottom surfaces of the second semiconductor layer 150.

Therefore, since the holes of the second semiconductor layer 150 are effectively supplied to the first and second active layers 140 and 160, the ratio of holes recombined with electrons to emit a light is actually increased. Accordingly, the light extraction efficiency of the light emitting device 100B can be improved.

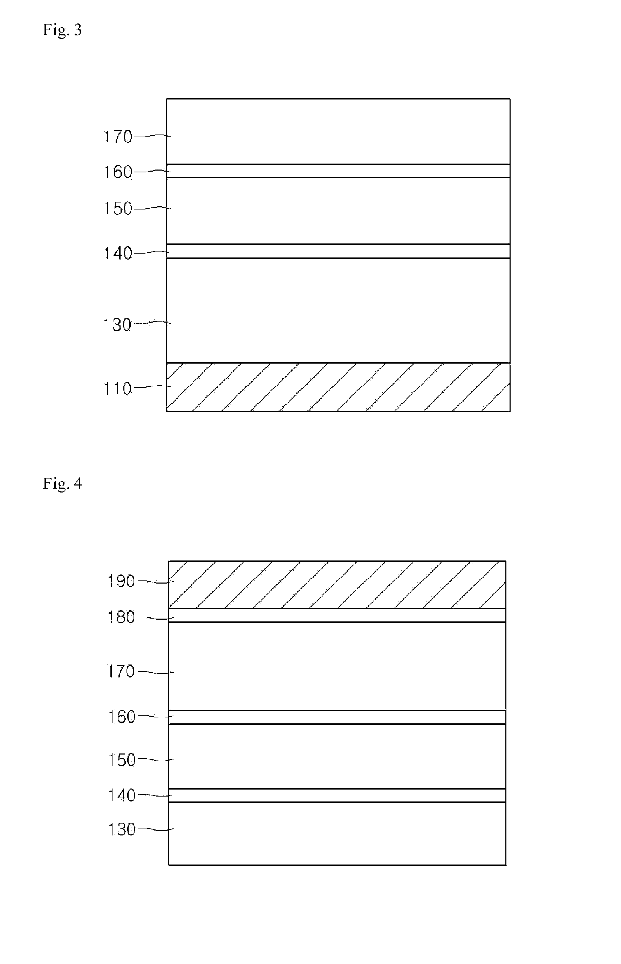

FIGS. 3 to 5 are views showing a method of fabricating the light emitting device 100B according to the second embodiment.

Referring to FIG. 3, the first semiconductor layer 130, the first active layer 140, the second semiconductor layer 150, the second active layer 160, and the third semiconductor layer 170 may be sequentially formed on the substrate 110.

Referring to FIG. 4, the reflective layer 180 is formed on the third semiconductor layer 170, and the conductive support member 190 may be formed on the reflective layer 180. In addition, after forming the conductive support member 190, the substrate 110 may be removed from the first semiconductor layer 130.

The reflective layer 180 may comprise at least one selected from the group consisting of silver (Ag), aluminum (Al), platinum (Pt), and palladium (Pd) representing higher reflectance.

The conductive support member 190 may comprise at least one selected from the group consisting of titanium (Ti), chromium (Cr), nickel (Ni), aluminum (Al), platinum (Pt), gold (Au), tungsten (W), copper (Cu), molybdenum (Mo), copper-tungsten (Cu-W) or carrier wafers (e.g., Si, Ge, GaN, GaAs, ZnO, SiC, or SiGe) that is a semiconductor substrate doped with impurities.

Meanwhile, if the reflective layer 180 does not form ohmic contact with respect to the third semiconductor layer 170, an ohmic layer may be interposed between the reflective layer 180 and the third semiconductor layer 170.

In order to improve the interfacial adhesion strength between the conductive support member 190 and the reflective layer 180, an adhesion layer may be provided between the conductive support member 190 and the reflective layer 180.

In addition, the reflective layer 180 may not be formed according to the designs of the light emitting device 100B, but the embodiment is not limited thereto.

The substrate 110 may be removed through at least one of an LLO (Laser Lift Off) process or an etching process, but the embodiment is not limited thereto.

After the substrate 110 has been removed, a portion of the first semiconductor layer 130 may be removed through an etching process such as an ICP/RIE (Inductively Coupled Plasma/Reactive Ion Etch) scheme. A portion of the first semiconductor layer 130 may be removed, so that the second semiconductor layer 150 sufficiently containing carriers can be exposed.

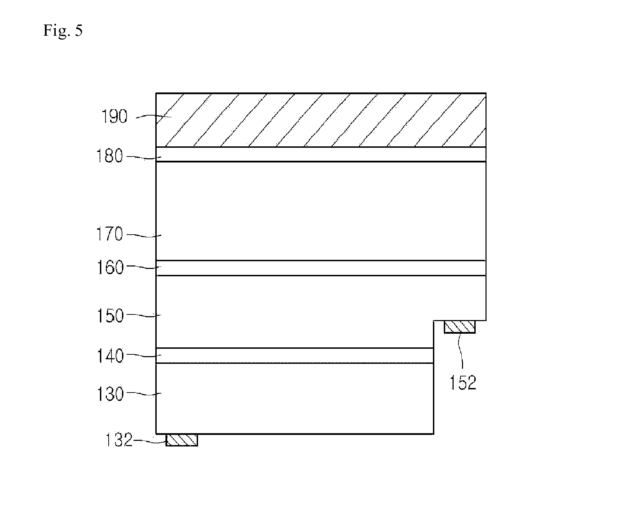

Referring to FIG. 5, the fifth electrode 132 is formed on the first semiconductor layer 130, and the fifth electrode 152 may be formed on the second semiconductor layer 150, thereby providing the light emitting device 100B according to the second embodiment.

After forming a mesa-etching process to expose the second semiconductor layer 150, the fifth electrode 132 may be formed, but the embodiment is not limited thereto.

The fourth and fifth electrodes 152 and 132 may overlap with the conductive support member 190 in a vertical direction. The fourth and fifth electrodes 152 and 132 may supply power to the light emitting device 100B.

### <Light Emitting Device Package>

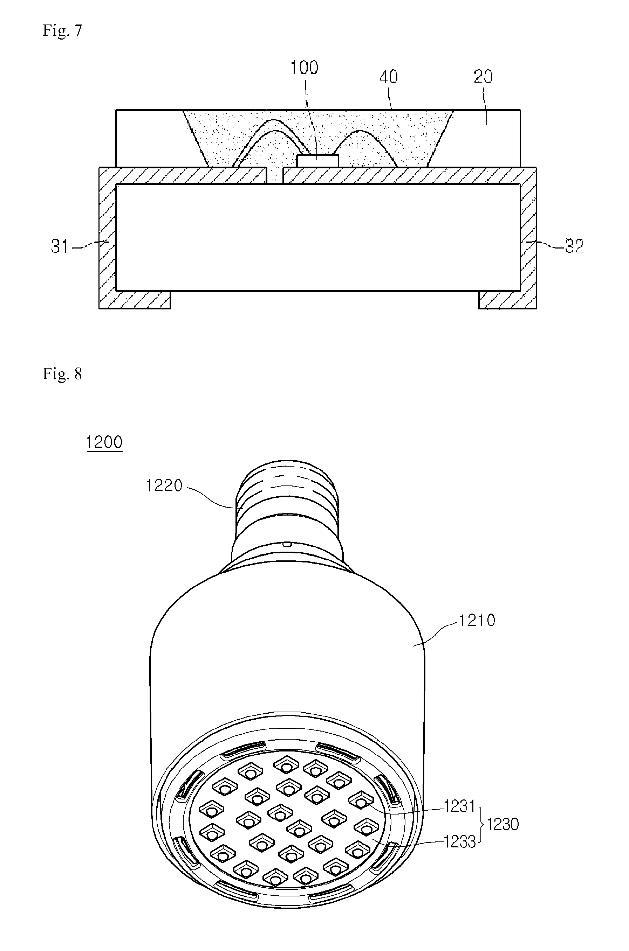

FIG. 7 is a sectional view showing a light emitting device package comprising the light emitting device according to the embodiment.

Referring to FIG. 7, the light emitting device package according to the embodiment comprises a body 20, first and second electrode layers 31 and 32 formed on the body 20, a light emitting device 100 provided on the body 20 and electrically connected to the first and second electrode layers 31 and 32 and a molding member 40 that surrounds the light emitting device 100.

The body 20 may comprise silicone, synthetic resin or metallic material. The lateral sides of the light emitting device 100 may be inclined.

The first and second electrode layers 31 and 32 are electrically isolated from each other to supply power to the light emitting device 100. In addition, the first and second electrode layers 31 and 32 improve the light efficiency by reflecting the light emitted from the light emitting device 100. Further, the first and second electrode layers 31 and 32 dissipate heat generated from the light emitting device 100 to the outside.

The light emitting device 100 may be provided on the body 20. The light emitting device 100 bay be provided on the first electrode layer 31 or the second electrode layer 32.

The light emitting device 100 is electrically connected to the first and second electrode layers 31 and 32 through a wire, but the embodiment is not limited thereto. For example, the light emitting device 100 may be electrically connected to the first and second electrode layers 31 and 32 through one of a wire scheme, a flip-chip scheme, and a die-bonding scheme.

The molding member 40 may surround the light emitting device 100 to protect the light emitting device 100. In addition, the molding member 40 may comprise a luminescence material to change the wavelength of the light emitted from the light emitting device 100.

FIG. 8 is a lighting apparatus 1200 employing the light emitting device according to the embodiments. The lighting apparatus 1200 is one example of the lighting apparatus 1200, but the embodiment is not limited thereto.

Referring to FIG. 8, the lighting system 1200 comprises a case body 1210, a light emitting module 1230 provided in the case body 1210, and a connection terminal 1220 provided in the case body 1210 to receive power from an external power source.

Preferably, the case body 1210 comprises material having superior heat dissipation property. For instance, the case body 1210 comprises metallic material or resin material.

The light emitting module 1230 may comprise a substrate 1232 and at least of a light emitting device 1231 according to the embodiment provided on the substrate 1232.

The substrate 1233 comprises an insulating member printed with a circuit pattern. For instance, the substrate 1233 comprises a PCB, an MCPCB, an FPCB, a ceramic PCB, and an FR-4 substrate.

In addition, the substrate 1233 may comprises material that effectively reflects the light. A coating layer may be formed on the surface of the substrate 1233. At this time, the coating layer has a white color or a silver color to effectively reflect the light.

At least one light emitting device 1231 according to the embodiment may be provided on the substrate 1233. Each light emitting device 1231 may comprise at least one LED (light emitting diode) chip. The LED chip may comprise an LED that emits the light of visible ray band having red, green, blue or white color and a UV (ultraviolet) LED that emits UV light.

Light emitting diodes of the light emitting module 1230 can be variously arranged to provide various colors and brightness. For instance, the white LED, the red LED and the green LED may be arranged to achieve the high color rendering index (CRI). In addition, a fluorescent sheet may be provided in the path of the light emitted from the light emitting module 1230 to change the wavelength of the light emitted from the light emitting module 1230. For instance, if the light emitted from the light emitting module 1230 has a wavelength band of blue light, the fluorescent sheet may comprise yellow luminescence material. In this case, the light emitted from the light emitting module 1230 passes through the fluorescent sheet so that the light is viewed as white light.

The connection terminal 1220 is electrically connected to the light emitting module 1230 to supply power to the light emitting module 1230. As shown in FIG. 8, the connection terminal 1220 has a shape of a socket screw-coupled with the external power source, but the embodiment is not limited thereto. For instance, the connection terminal 1220 may be prepared in the form of a pin inserted into the external power source or connected to the external power source through a wire.

According to the lighting apparatus as described above, at least one of the light guide member, the diffusion sheet, the light collection sheet, the brightness enhancement sheet and the fluorescent sheet is provided in the path of the light emitted from the light emitting module, so that the desired optical effect can be achieved.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A light emitting device comprising:
a first semiconductor layer (130) doped with N type dopants;
a first active layer (140) on the first semiconductor layer (130);
a second semiconductor layer (150) doped with P type dopants on the first active layer (130);
a second active layer (160) on the second semiconductor layer (150); and
a third semiconductor layer (170) doped with N type dopants on the second active layer (160),
wherein a thickness of the second semiconductor layer (150) is in a range of 2000Å to 4000Å, and doping concentration of the P type dopants doped in the second semiconductor layer (150) is in a range from 10¹⁸cm⁻³ to 10²¹cm⁻³ .

2. The light emitting device of claim 1, wherein a total thickness of the first semiconductor layer (130), the first active layer (140), the second semiconductor layer (150), the second active layer (160), and the third semiconductor layer (170) is at least 7µm.

3. The light emitting device of claim 1, wherein the first semiconductor layer (130), the first active layer (140), the second semiconductor layer (150), the second active layer (160), and the third semiconductor layer (170) comprise a material having a compositional formula of InₓAl_{y}Ga_{1-x-y}N (0≤x≤1, 0≤y≤1, and 0≤x+y≤1).

4. The light emitting device of claim 1, wherein the first and second active layers (140, 160) emit lights having same wavelength bands.

5. The light emitting device of claim 1, wherein the first and second active layers (140, 160) emit lights having wavelength bands different from each other.

6. The light emitting device of claim 1, further comprising a first electrode (131) on the first semiconductor layer (130), a second electrode (151) on the second semiconductor layer (150), and a third electrode (171) on the third semiconductor layer (170).

7. The light emitting device of claim 6, wherein at least portions of the first, second, and third electrodes (131, 151, 171) are aligned on a same diagonal plane.

8. The light emitting device of claim 6, wherein top surfaces of the first semiconductor layer (130), the second semiconductor layer (150), and the third semiconductor layer (170) have a shape including a vertex, and the first, second, and third electrodes (131, 151, 171) are provided adjacent to vertexes, which are different from each other and formed on the top surfaces of the first semiconductor layer (130), the second semiconductor layer (150), and the third semiconductor layer (170), respectively.

9. The light emitting device of claim 1, further comprising an undoped semiconductor layer, a buffer layer, and a substrate (110) under the first semiconductor layer (130).

10. The light emitting device of claim 1, further comprising at least one of a reflective layer (180) and a conductive support member (190) on the third semiconductor layer (170).

11. The light emitting device of claim 10, further comprising a fourth electrode (152) on the second semiconductor layer (150) and a fifth electrode (132) on the first semiconductor layer (130).

12. A light emitting device package comprising:
a body (20);
first and second electrode layers (31, 32) on the body (20);
a light emitting device (100) according to any one of claims 1 to 11, provided on the body (20), and electrically connected to the first and second electrode layers (31, 32); and
a molding member (40) surrounding the light emitting device (100) on the body (20).

13. A lighting apparatus comprising:
a case (1210);
a light emitting module (1230) provided in the case (1210) and comprising at least one of a light emitting device (1231) according to any one of claims 1 to 11; and
a connection terminal (1220) provided in the case to receive power from an external power source.

14. The lighting apparatus of claim 13, wherein the light emitting module comprises a substrate, and the light emitting device is provided on the substrate.

15. The lighting apparatus of claim 14, wherein the substrate comprises one selected from the group consisting of a printed circuit board (PCB), a metal core PCB, a flexible PCB, and a ceramic PCB.
